(19) Europäisches Patentamt
European Patent Office
Office européen des brevets

(11) **EP 2 808 687 A1**

(12) **EUROPEAN PATENT APPLICATION**
published in accordance with Art. 153(4) EPC

(43) Date of publication:
**03.12.2014 Bulletin 2014/49**

(51) Int Cl.:
***G01R 31/02*** *(2006.01)*

(21) Application number: **11870828.8**

(86) International application number:
**PCT/JP2011/080173**

(22) Date of filing: **27.12.2011**

(87) International publication number:
**WO 2013/098932 (04.07.2013 Gazette 2013/27)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(71) Applicant: **Hitachi, Ltd.**
**Tokyo 100-8280 (JP)**

(72) Inventors:
• **TAKAHASHI, Toshiki**
**Hitachi-shi, Ibaraki 319-1292 (JP)**

• **YAMAUCHI, Shin**
**Hitachi-shi, Ibaraki 319-1292 (JP)**

(74) Representative: **Beetz & Partner**
**Patentanwälte**
**Steinsdorfstraße 10**
**80538 München (DE)**

(54) **BATTERY SYSTEM, AND GROUND-FAULT DETECTION DEVICE**

(57) A first battery pack (252-1) comprises a battery module (314) which includes a plurality of battery cells (310) connected in series between a positive terminal (352) and a negative terminal (353), ground-fault resistances (45) each of which appears between a grounding point (23) and an inter-battery connection point (311) between adjoining ones of the battery cells (310), a booster unit (11) which is provided to the positive terminal (352) and outputs boosted electric potential acquired by boosting high electric potential of the battery module (314), a protective resistance (25) and a ground fault detecting resistance (27) which are provided in series between a third connection point (19) (on the output side of the booster unit (11)) and the grounding point (23), and a ground fault detecting unit (41) which detects the presence/absence of a ground fault in the battery module (314) based on the result of comparison between preset threshold electric potential (Vref) and electric potential of an inter-resistance connection point (29) between the protective resistance (25) and the ground fault detecting resistance (27).

FIG.4

EP 2 808 687 A1

**Description**

Technical Field

The present invention relates to a battery system having a ground fault detecting function for detecting a ground fault occurring in an electric current path, and a ground fault detecting device.

Background Art

It is necessary to constantly maintain the electrically insulating state between electric current paths and the ground. If the electrically insulating state is broken due to occurrence of some type of abnormality, a phenomenon called "ground fault" occurs, in which the electric current passing through an electric current path flows into the ground.

As a conventional ground fault detecting technique for detecting a ground fault occurring in an electric current path, there exists a known technique that detects the presence/absence of a ground fault by sensing the ground-fault current flowing from the ground fault point through a grounding point. However, such ground fault detecting techniques involve a problem called "dead zone". Specifically, when a ground fault has occurred at particular electric potential at which no electromotive force causing ground-fault current occurs (reference electric potential of the ground fault detecting circuit), it is impossible to detect the presence/absence of a ground fault since no ground-fault current flows.

In order to eliminate such a dead zone of the ground fault detection, Patent Literature 1 has disclosed a ground fault detecting technique in which a plurality of reference electric potentials of the ground fault detecting circuit are prepared and the ground fault detection is carried out by dynamically switching the reference electric potential among the prepared reference electric potentials.

In the ground fault detecting technique of the Patent Literature 1, ground faults occurring not on the negative terminal's side of a non-grounded DC power supply (occurring inside or on the positive terminal's side of the non-grounded DC power supply) are detected by using a first ground fault detecting circuit that employs electric potential on the negative terminal's side of the non-grounded DC power supply as the reference electric potential. In contrast, ground faults occurring on the negative terminal's side are detected by using a second ground fault detecting circuit that employs electric potential not on the negative terminal's side (arbitrary electric potential within an electric potential range possible inside or on the positive terminal's side of the non-grounded DC power supply) as the reference electric potential, for example.

With the ground fault detecting technique of the Patent Literature 1, the presence/absence of occurrence of a ground fault can be detected accurately without causing the dead zone of the ground fault detection.

Prior Art Literature

Patent Literature

Patent Literature 1: JP-2005-189005-A

Summary of the Invention

Problem to be Solved by the Invention

However, the ground fault detecting technique of the Patent Literature 1 needs a control circuit for the dynamic switching of the reference electric potential for the ground fault detection. Therefore, the technique involves problems such as time delay of the detection and complication of the device configuration due to the switching.

The object of the present invention which has been made in consideration of the above situation is to provide a battery system and a ground fault detecting device capable of accurately detecting the presence/absence of a ground fault in real time with a simple configuration.

Means for Solving the Problem

A battery system in accordance with the present invention is principally characterized in that it comprises: a DC power supply unit which includes a plurality of batteries connected in series between a pair of non-grounded terminals; ground-fault resistances each of which appears between a grounding point and an inter-battery connection point between adjoining ones of the batteries; a booster unit which is provided to one of the non-grounded terminals on a high electric potential side and outputs boosted electric potential acquired by boosting the high electric potential; a protective resistance and a ground fault detecting resistance which are provided in series between the output side of the booster unit and the grounding point; and a ground fault detecting unit which detects the presence/absence of a ground fault in the DC power supply unit based on the result of comparison between preset threshold electric potential and electric potential of an inter-resistance connection point between the protective resistance and the ground fault detecting resistance.

Effect of the Invention

With the battery system in accordance with the present invention, the presence/absence of a ground fault can be detected accurately in real time with a simple configuration.

Brief Description of the Drawings

Fig. 1 is a block diagram showing the outline of an electric power system to which a battery system in accordance with the present invention is applied.
Fig. 2 is a block diagram conceptually showing the hierarchical structure of the battery system in accordance with the present invention.
Fig. 3A is a circuit configuration diagram of the battery system in accordance with the present invention.
Fig. 3B is a circuit configuration diagram magnifying a part of the battery system of Fig. 3A around a battery pack.
Fig. 4 is a circuit configuration diagram showing a first battery pack (corresponding to a battery system in accordance with a first embodiment of the present invention) and a ground fault detecting device.
Fig. 5 is a flow chart showing the flow of a ground fault detecting operation of the first battery pack and the ground fault detecting device.
Fig. 6 is a time chart contrasting an output voltage waveform of a comparator and a ground fault detection signal waveform in a case where a ground fault has occurred.
Fig. 7A is an explanatory diagram showing a closed-loop circuit formed in the first battery pack (first ground fault detecting device) when a ground fault has occurred and the output of a booster unit is boosted electric potential (with boosting).
Fig. 7B is an explanatory diagram showing a closed-loop circuit formed in the first battery pack (first ground fault detecting device) when a ground fault has occurred and the output of the booster unit is high electric potential (without boosting).
Fig. 8 is a circuit configuration diagram showing a second battery pack (corresponding to a battery system in accordance with a second embodiment of the present invention) and a ground fault detecting device.

Mode for Carrying out the Invention

In the following, battery systems in accordance with first and second embodiments of the present invention will be described with reference to figures.

<Outline of Battery System in Accordance with Present Invention>

First, the outline of the battery system in accordance with the present invention will be described below as a concept covering the battery systems in accordance with the first and second embodiments of the present invention.
The battery system in accordance with the present invention comprises a ground fault detecting device having a ground fault detecting function. The battery system and the ground fault detecting device in accordance with the present invention are principally characterized in that they comprise a DC power supply unit which includes a plurality of batteries connected in series between a pair of non-grounded terminals, ground-fault resistances each of which appears between a grounding point and an inter-battery connection point between adjoining ones of the batteries, a booster unit which is provided to one of the non-grounded terminals on a high electric potential side and outputs boosted electric potential acquired by boosting the high electric potential, a protective resistance and a ground fault detecting resistance which are provided in series between the output side of the booster unit and the grounding point, and a ground fault detecting unit which detects the presence/absence of a ground fault in the DC power supply unit based on the result of comparison between preset threshold electric potential and electric potential of an inter-resistance connection point between the protective resistance and the ground fault detecting resistance.
In the aforementioned DC power supply unit, each inter-battery connection point between adjoining ones of the batteries is insulated from the grounding point (electric potential of the ground). Specifically, in the normal state in which no ground fault has occurred, resistance on the order of M$\Omega$ (corresponding to the "ground-fault resistance" in the present invention) exists between each inter-battery connection point and the grounding point.

The present inventors were intensively pursuing our researches in order to resolve the inevitable problems with the conventional ground fault detecting technology such as the time delay of the detection and the complication of the device configuration due to the dynamic switching among multiple levels of ground fault detection reference electric potentials. We were repeating trial-and-error efforts especially to implement the ground fault detection by use of a single ground fault detection reference electric potential.

In the meantime, the present inventors came up with the idea that it may be possible to implement the ground fault detection by use of a single ground fault detection reference electric potential without causing the so-called "dead zone" (ground fault detection disabling electric potential) if the ground fault detection reference electric potential is acquired outside the DC power supply unit.

In the process of brushing up the above idea, the present inventors found that not only the presence/absence of a ground fault but also ground fault occurrence status (the position where a ground fault occurred, the magnitude of the ground fault) is detectable, and completed the present invention based on the finding.

With the battery system and the ground fault detecting device in accordance with the present invention, the presence/absence of a ground fault can be detected accurately in real time with a simple configuration.

Electric power systems generating electric power from natural energy (wind power generation, photovoltaic power generation, etc.) are advantageous in that their load on the natural environment is light. However, the power generation capacities of such electric power systems fluctuate dependently on the natural environment. Specifically, the intensity of wind or sunlight changes from moment to moment and there is apprehension about ill effects on the electric power systems, such as frequency fluctuation and voltage fluctuation.

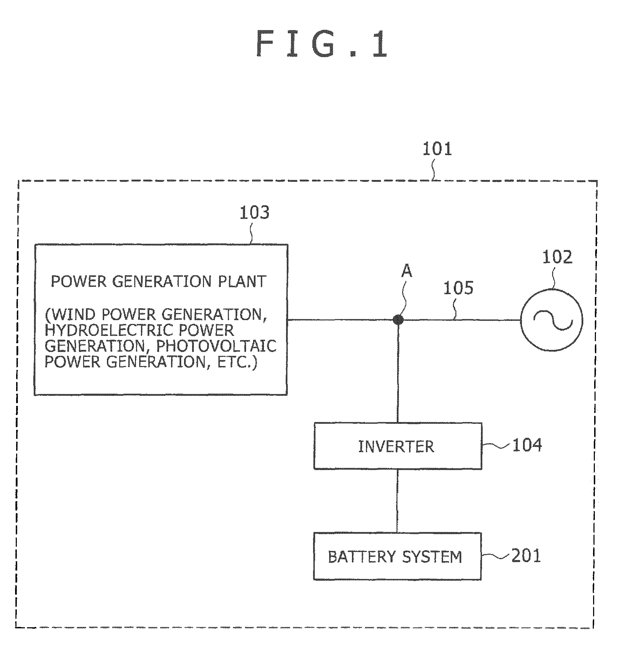

As one of approaches for eliminating such apprehension, there has been proposed an electric power system in which a natural energy power generation plant is equipped with a battery system in order to reduce the frequency fluctuation and the voltage fluctuation of the electric power system. Fig. 1 is a block diagram showing the outline of an electric power system 101 to which the battery system 201 in accordance with the present invention is applied.

As shown in Fig. 1, the electric power system 101 comprises an electric system 102, a power generation plant 103, an inverter 104, and the battery system 201 in accordance with the present invention. Incidentally, the battery system 201 in accordance with the present invention represents the concept covering both of the battery systems in accordance with the first and second embodiments which will be described later.

The power generation plant 103 has the function of supplying electric power generated from natural energy, for example, to the electric system 102. To a connection point A in a power line 105 between the power generation plant 103 and the electric system 102, the battery system 201 in accordance with the present invention is connected via the inverter 104.

The inverter 104 has the function of converting the electric power generated by the power generation plant 103 to DC power and sending the DC power to the battery system 201, as well as the function of converting the DC power stored in the battery system 201 into AC power and sending the AC power to the electric system 102. The electric power is fed to loads via the AC electric system 102.

In cases where such a natural energy power generation plant 103 is employed as the power generation plant 103, the output of the plant is affected by changes in the natural environment (weather, seasons, etc.) and fluctuates. This output fluctuation causes frequency fluctuation and voltage fluctuation in the electric system 102, serving as a factor deteriorating the electric power quality of the electric system 102.

In this regard, the battery system 201 in accordance with the present invention functions to keep the frequency fluctuation and the voltage fluctuation of the electric system 102 within prescribed ranges. Specifically, the battery system 201 charges itself with excess electric power when excessive electric power is supplied to the electric system 102, while discharging the stored electric power when the electric system 102 is short of electric power (so-called "buffer function"). With this function, the battery system 201 in accordance with the present invention is capable of suppressing the frequency fluctuation and the voltage fluctuation of the electric system 102.

<Specific Configuration of Battery System 201 in Accordance with Present Invention>

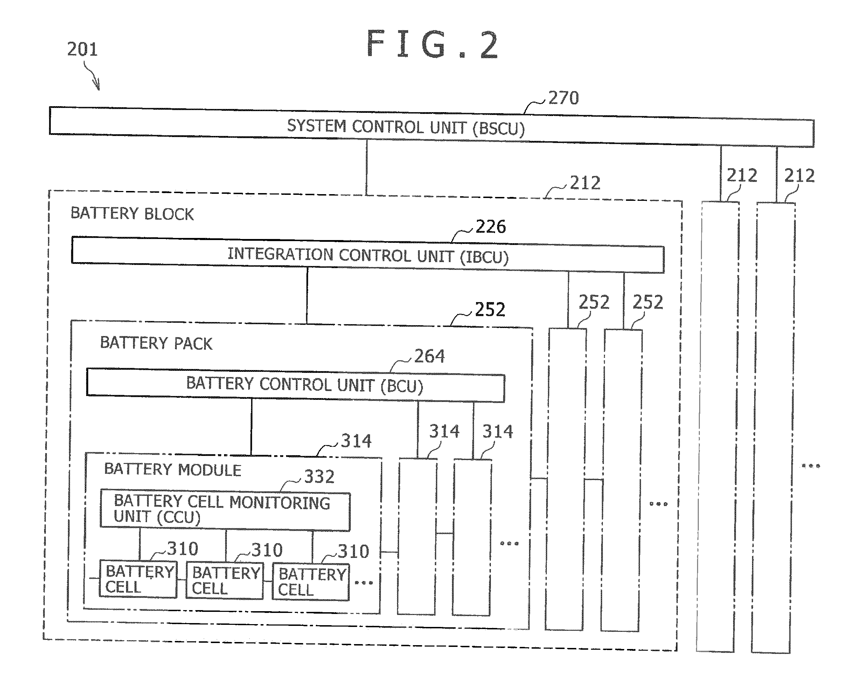

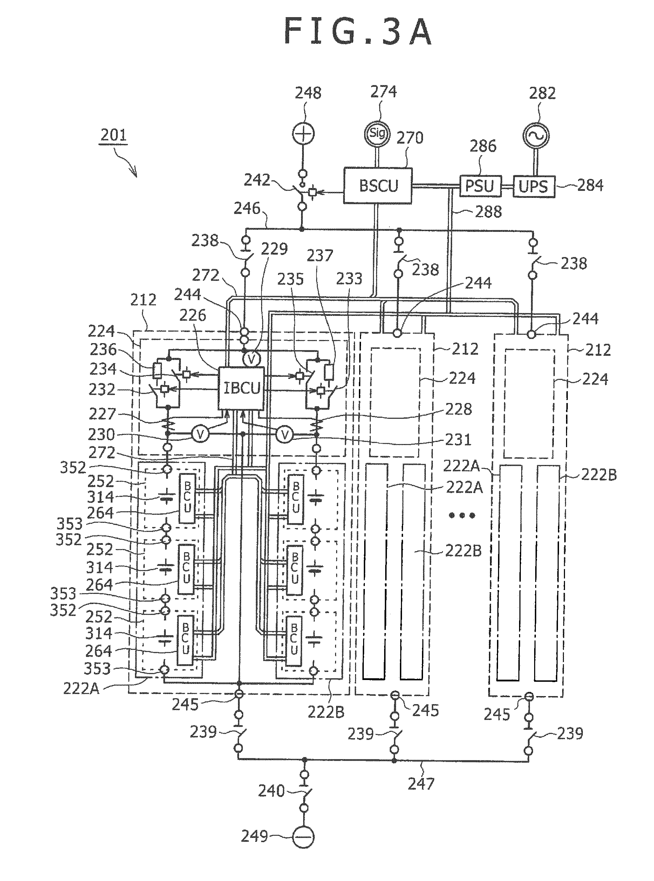

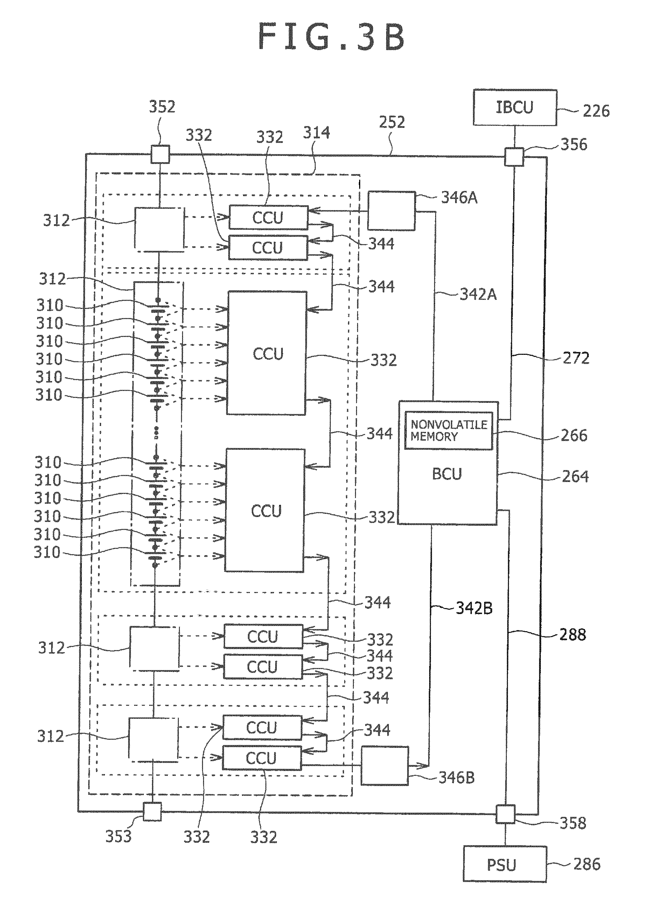

Next, the specific configuration of the battery system 201 in accordance with the present invention will be described referring to Fig. 2, Fig. 3A and Fig. 3B.

Fig. 2 is a block diagram conceptually showing the hierarchical structure of the battery system 201 in accordance with the present invention. Fig. 3A is a circuit configuration diagram of the battery system 201 in accordance with the present invention. Fig. 3B is a circuit configuration diagram magnifying a part of the battery system 201 of Fig. 3A around a battery pack 252.

As shown in Fig. 2 and Fig. 3A, the battery system 201 in accordance with the present invention hierarchically comprises battery modules 314 each including a plurality of battery cells 310 connected in series, battery packs 252 each including a plurality of battery modules 314 connected in series-parallel connection, and battery blocks 212 each including a plurality of battery packs 252 connected in parallel.

The "series-parallel connection" means connecting a plurality of components in series (to form a series connection part) and further connecting the series connection parts in parallel.

<Configuration of Battery Module 314>

In the battery system 201 in accordance with the present invention, the minimum-scale basic unit among basic units constituting the battery system 201 is the battery module 314. All the battery modules 314 have the same basic configuration, and thus the following explanation of the battery modules 314 will be given by explaining the configuration of one of the battery modules 314 as a representative example (ditto for the battery packs 252 and the battery blocks 212 which will be explained later).

As shown in Figs. 3A and 3B, each battery module 314 is connected in series to battery modules 314 of other battery packs 252 via a positive terminal 352 and a negative terminal 353. As shown in Fig. 3B, each battery module 314 includes four battery groups 312. Each of the four battery groups 312 includes twelve battery cells 310 as a group.

Each of the four battery groups 312 included in one battery module 314 is equipped with a pair of battery cell monitoring units (CCUs) 332 as shown in Figs. 2 and 3B. Thus, each battery group 312 is managed by a pair of battery cell monitoring units (CCUs) 332 in a load sharing manner. The twelve battery cells 310 as a group are partitioned into six battery cells 310 on the high-voltage side and six battery cells 310 on the low-voltage side. Both terminals (high-voltage terminal, low-voltage terminal) of each battery cell 310 are connected to input terminals (unshown) of the pair of battery cell monitoring units (CCUs) 332.

One battery cell monitoring unit (CCU) 332 is in charge of managing six battery cells 310 in this example. However, the number of battery cells 310 managed by one battery cell monitoring unit (CCU) 332 may be set arbitrary. For example, it is possible to employ three battery cell monitoring units (CCUs) 332 each managing four battery cells 310.

Each of the high-voltage side battery cell monitoring unit (CCU) 332 and the low-voltage side battery cell monitoring unit (CCU) 332 detects the inter-terminal voltage (voltage between the terminals) of each battery cell 310 connected to its input terminals and calculates the state of charge (hereinafter abbreviated as "SOC" in some cases) of each battery cell 310 based on the detected inter-terminal voltage of the battery cell 310. Further, each battery cell monitoring unit (CCUs) 332 further conducts a diagnosis on the overcharge/overdischarge based on the inter-terminal voltage of each battery cell 310.

<Configuration of Battery Pack 252>

In the battery system 201 in accordance with the present invention, the basic unit on a hierarchical scale immediately above the battery modules 314 (among the basic units constituting the battery system 201) is the battery pack 252. In the example of Fig. 2, three battery packs 252 are illustrated.

Each battery pack 252 includes a battery control unit (BCU) 264 as shown in Figs. 2, 3A and 3B. While a plurality of battery modules 314 are connected to the battery control unit (BCU) 264 in Fig. 2 to operate under the control of the battery control unit (BCU) 264, only one battery module 314 is connected to the battery control unit (BCU) 264 in Fig. 3B for brief illustration of the configuration. The following explanation will be given on the assumption that a plurality of battery modules 314 operate under the control of the battery control unit (BCU) 264. Incidentally, reference characters 222A and 222B are not shown in Fig. 2.

The battery control unit (BCU) 264 receives SOC information regarding the state of charge (SOC) of each battery cell 310 from the battery cell monitoring units (CCUs) 332 belonging to the battery modules 314 under its control. Based on the SOC information, the battery control unit (BCU) 264 performs management (including the diagnosis on the overcharge/overdischarge) of the battery modules 314 under its control.

Further, the battery control unit (BCU) 264 reports the above SOC information, etc. to an integration control unit (IBCU) 226 and a system control unit (BSCU) 270 operating as its upper-level control units.

<Configuration of Battery Block 212>

In the battery system 201 in accordance with the present invention, the basic unit on the uppermost hierarchical scale among the basic units of the battery system 201 is the battery block 212. In the example of Fig. 2, three battery blocks 212 are illustrated.

As shown in Fig. 3A, each battery block 212 is formed by connecting two battery units 222A and 222B in parallel. Each battery unit 222A, 222B includes a plurality of battery packs 252. In the battery system 201 in accordance with the present invention, each battery unit 222A, 222B includes three battery packs 252.

Depending on the DC voltage to be stored, the two battery units 222A and 222B included in each battery block 212 may also be connected in series. The number of battery units 222A, 222B included in each battery block 212 is not limited to two; the number may be set properly in consideration of the purpose and conditions of use of the battery system 201 in accordance with the present invention.

Each battery block 212 includes the integration control unit (IBCU) 226 as shown in Figs. 2, 3A and 3B. The integration control unit (IBCU) 226 receives the SOC information regarding the state of charge (SOC) of each battery cell 310 from the battery cell monitoring units (CCUs) 332 of the battery modules 314 belonging to each battery pack 252 under its control. Based on the SOC information, the integration control unit (IBCU) 226 performs management (including the diagnosis on the overcharge/overdischarge) of the battery packs 252 under its control.

Further, the integration control unit (IBCU) 226 reports the above SOC information, etc. to the system control unit (BSCU) 270 operating as its upper-level control unit.

<Configuration of Integration Unit 224>

Each battery block 212 includes an integration unit 224 as shown in Fig. 3A. As shown in Fig. 3A, each integration unit 224 includes relays 232, 233, 234 and 235, current sensors 227 and 228, and voltage sensors 229, 230 and 231 in addition to the integration control unit (IBCU) 226. The integration control unit (IBCU) 226 manages the components inside the battery block 212. The relays 232, 233, 234 and 235 operate to electrically open/close the electricity feeding paths of the battery units 222A and 222B. The current sensors 227 and 228 detect the magnitudes of electric currents passing through the battery units 222A and 222B, respectively.

The voltage sensor 229 detects positive terminal voltage (voltage of a positive terminal 244) of a main power supply line of the battery system 201 in accordance with the present invention as shown in Fig. 3A. The voltage sensors 230 and 231 detect positive terminal voltages of the electricity feeding paths of the battery units 222A and 222B, respectively. Specifically, each voltage sensor 230, 231 detects the inter-terminal voltage of each battery unit 222A, 222B.

The integration control unit (IBCU) 226 receives values of charging/discharging currents detected by the current sensors 227 and 228, voltage values of parts detected by the voltage sensors 229, 230 and 231, and various types of information including information on the ground fault occurrence status supplied from the battery packs 252 under its control, or information supplied from the system control unit (BSCU) 270. Based on the various types of received information and detected values, the integration control unit (IBCU) 226 performs the switching control (opening/closing) of the relays 232, 233, 234 and 235.

Further, the integration control unit (IBCU) 226 reports the various types of information (including the ground fault occurrence status) supplied from the battery packs 252, the charging/discharging current values detected by the current sensors 227 and 228, and the voltage values of the parts detected by the voltage sensors 229, 230 and 231 to the system control unit (BSCU) 270 on the upper level.

<Operations of Relays 232 and 234 and Switches 238, 239, 240 and 242>

In the battery system 201 in accordance with the present invention, the maintenance check is conducted for each battery unit 222A, 222B. Therefore, the use of the battery system 201 is stopped for the period of the maintenance check. The state of charge (SOC) of such a battery cell 310 stopped from being used differs gradually from those of battery cells 310 continuing the operation. When battery units 222 differing in the state of charge (SOC) are connected in parallel, a high current can flow from a battery unit 222 in a higher state of charge (SOC) to a battery unit 222 in a lower state of charge (SOC). Further, also when a ground fault occurred in one of the battery units 222, a high current can flow to the ground terminal.

To avoid the risk related to the passage of a high current, each battery unit 222A, 222B is equipped with a current limiter 236, 237. For example, when the battery unit 222A is connected between a positive terminal wiring 246 and a negative terminal wiring 247, the relay 232 is closed first. By this operation, the battery unit 222A is connected between the positive terminal wiring 246 and the negative terminal wiring 247 via the current limiter 236. In this case, the current flowing through the current limiter 236 is detected by the current sensor 227.

When the current detected by the current sensor 227 (charging/discharging current of the battery unit 222A) is less than or equal to a preset value, the relay 234 is closed and thereafter the relay 232 is opened. By employing such a procedure, the charging/discharging current of the battery cell 310 is converged on a safe value.

In the battery system 201 in accordance with the present invention, a lithium-ion secondary battery is employed as each battery cell 310. The inter-terminal voltage of a lithium-ion secondary battery changes according to the SOC, and thus the current at the time of turning ON the relay 234 can be predicted by using the voltage value detected by the voltage sensor 230. It is possible to employ a configuration which turns ON the relay 232 to improve the safety (so as to limit the current to a safe value with the current limiter 236) when the battery unit 222A is put in and then controls the turning ON of the relay 234 based on the voltage value detected by the voltage sensor 230.

When the voltage value detected by the voltage sensor 230 is within a prescribed range with respect to the inter-terminal voltage of the other battery unit 222B, the relay 234 may be turned ON immediately, without turning ON the relay 232. Incidentally, the relays 233 and 235 for the battery unit 222B are also controlled similarly to the procedure for the battery unit 222A explained above.

As shown in Fig. 3A, the positive terminals 244 of the battery blocks 212 (among the positive and negative terminals of the battery blocks 212) are connected in parallel to the positive terminal wiring 246 via disconnecting switches 238, respectively. The positive terminal wiring 246 is connected to a positive output terminal 248 via one breaker 242. The breaker 242 is controlled (opened/closed) according to a control signal supplied from the system control unit (BSCU) 270.

Similarly, negative terminals 245 of the battery blocks 212 are connected in parallel to the negative terminal wiring 247 via disconnecting switches 239, respectively as shown in Fig. 3A. The negative terminal wiring 247 is connected to a negative output terminal 249 via one breaker 240.

In the following explanation, the disconnecting switches 238 and 239 and the breakers 240 and 242 can be collectively referred to as "switches". When the switches 238, 239, 240 and 242 are closed, the battery blocks 212 are connected in parallel to the positive output terminal 248 and the negative output terminal 249 as shown in Fig. 3A. Similarly, the battery system 201 in accordance with the present invention is connected to the positive output terminal 248 and the negative output terminal 249, that is, connected to the inverter 104.

When the battery system 201 shown in Fig. 3A is electrically disconnected from the electric power system 101 shown in Fig. 1 (i.e., disconnected from the inverter 104), the following procedure is performed in the battery system 201 as the target of the disconnection: First, according to a command from the system control unit (BSCU) 270, the breaker 242 is opened and the charging/discharging currents of the battery modules 314 are blocked. Thereafter, the switches 238, 239 and 240 are opened successively.

Conversely, when the battery system 201 shown in Fig. 3A is connected in parallel to other battery systems 201, the following procedure is performed in the battery system 201 as the target of the connection: First, the switches 238, 239 and 240 are closed successively. Thereafter, the breaker 242 is closed according to a command from the system control unit (BSCU) 270.

<Information Transmission and Control of Battery System 201>

In the battery system 201 in accordance with the present invention, the information from each integration control unit (IBCU) 226 is transmitted to the system control unit (BSCU) 270 via an information bus 272, for example. Further, from a management device (unshown) of the battery system 201 shown in Fig. 1, various types of information are sent to the system control unit (BSCU) 270 via an information input/output terminal 274.

The system control unit (BSCU) 270 performs the switching control (opening/closing) of the breaker 242. The system control unit (BSCU) 270 executes control to open the breaker 242 when a condition for electrically disconnecting the battery system 201 from the other battery systems 201 is satisfied based on information/request from an integration control unit (IBCU) 226 or information from a management device of an upper-level battery system 201.

When the breaker 242 is opened, the battery system 201 is electrically disconnected from the electric power system 101 shown in Fig. 1, by which the flow of electric currents inside the battery system 201 is stopped. Thereafter, the breaker 240 is opened and the disconnecting switches 238 and 239 of the battery blocks 212 are also opened. By opening (disconnecting) the electricity feeding paths of the battery system 201 according to the above procedure, the maintenance check work in units of battery systems 201 (for each individual battery system 201) can be performed with ease while securing the safety during the work.

<Supply of Electric Power for Control>

In the battery system 201 in accordance with the present invention, the various functions of the system control unit (BSCU) 270, the integration control units (IBCUs) 226 and the battery control units (BCUs) 264 shown in Fig. 3A are implemented by software installed in microcomputers. Therefore, control electric power (electric power for control) for the operation of the microcomputers has to be supplied to the microcomputers.

Each microcomputer operates with relatively low DC power (approximately 5V, for example). Therefore, instead of the DC power stored inside the battery system 201, DC power obtained by converting AC power is used in the battery system 201 in accordance with the present invention. However, the DC power to be supplied to the microcomputers may either be obtained by converting AC power supplied from the outside into DC power or by using the DC power stored inside.

To the battery system 201 in accordance with the present invention, the AC power from the outside is supplied via a control power supply input terminal 282 as shown in Fig. 3A. The AC power via the control power supply input terminal 282 is supplied to an uninterruptible power supply unit (UPS) 284. Normally, the DC power necessary for the control is generated from the AC power supplied via the control power supply input terminal 282. When the supply of AC power from the outside stops, the necessary DC power is supplied by the uninterruptible power supply unit (UPS) 284 instead.

The DC power from the uninterruptible power supply unit (UPS) 284 is supplied to the system control unit (BSCU) 270, the integration control units (IBCUs) 226 and the battery control units (BCUs) 264 via a power supply unit (PSU) 286.

Since the battery system 201 in accordance with the present invention is equipped with the uninterruptible power supply unit (UPS) 284, the operation of the battery system 201 can be continued even in case of an abnormality like the stoppage of the AC power from the control power supply input terminal 282. This is because the use of the AC power from the outside is switched to the use of the DC power supplied from the uninterruptible power supply unit (UPS) 284 in case of such an abnormality.

<Transmission Path in Battery Pack 252>

As shown in Fig. 3B, two insulated circuits (serial transmission paths) 346A and 346B inside the battery pack 252 are connected to the battery control unit (BCU) 264 via first transmission lines 342A and 342B, respectively. Each of second transmission lines 344 connects adjoining battery cell monitoring units (CCUs) 332 together. The battery control unit (BCU) 264 operates with the DC power supplied via a control power supply line 288 as shown in Fig. 3A.

Each battery cell monitoring unit (CCU) 332 operates with DC power supplied from the battery cells 310 under its control. Therefore, the reference electric potential of the power supply voltage supplied to the battery control unit (BCU) 264 and that of the power supply voltage supplied to each battery cell monitoring unit (CCU) 332 differ from each other. In other words, the electric potential of the first transmission lines 342A and 342B and that of the second transmission lines 344 differ from each other. Therefore, the first transmission lines 342A and 342B are connected to the second transmission lines 344 via insulating circuits 346A and 346B, respectively.

Specifically, the insulating circuits 346A and 346B are implemented by photocouplers, transformers, etc. Each insulating circuit 346A, 346B serves to temporarily modulate (convert) an electric signal into an optical signal or magnetic flux signal as another type of transmission medium and thereafter demodulate the signal into an electric signal, by which the electrical insulation between the first transmission lines 342A, 342B and the second transmission lines 344 can be maintained reliably.

While data transmission is performed from a battery cell monitoring unit (CCU) 332 at higher electric potential successively toward the low electric potential side in the battery system 201 in accordance with the present invention, reverse transmission from the low electric potential side toward the high electric potential side is also possible. The electrical connection from the output terminal of a battery cell monitoring unit (CCU) 332 to the input terminal of the next battery cell monitoring unit (CCU) 332 may be made via an electrical resistance and a diode, or via a capacitor.

Data addressed to each battery cell monitoring unit (CCU) 332 transmitted by the battery control unit (BCU) 264 is sent to the insulating circuit 346A via the first transmission line 342A. Subsequently, the data is sent from the insulating circuit 346A to the battery cell monitoring unit (CCU) 332 on the high electric potential side via the second transmission line 344. The data which passed through the second transmission lines 344 is transmitted to the insulating circuit 346B and then returns to the battery control unit (BCU) 264 via the first transmission line 342B.

Each battery cell monitoring unit (CCU) 332 checks whether address data included in received data has been addressed to itself or not, and responds to the received data if the address data is addressed to itself. Further, the battery cell monitoring unit (CCU) 332 adds requested information to the received data as needed according to the contents of the command and transmits the data to the next battery cell monitoring unit (CCU) 332 in the transmitting direction.

Each battery cell monitoring unit (CCU) 332 adds various types of detection results and diagnosis results to the received data in response to the request from the battery control unit (BCU) 264 and transmits the data to the battery control unit (BCU) 264. Each battery cell monitoring unit (CCU) 332 is capable of making various types of diagnoses in addition to the diagnosis on the overcharge/overdischarge and may add the results of such diagnoses to the data to be transmitted.

The battery control unit (BCU) 264 is connected to the integration control unit (IBCU) 226 (upper-level control unit) via the information bus 272 and an information bus connector 356. The data of the various types of detection results and diagnosis results received by the battery control unit (BCU) 264 via the second transmission lines 344 is transmitted to the integration control unit (IBCU) 226.

The data of the various types of detection results and diagnosis results received by the battery control unit (BCU) 264 is also stored and held in a nonvolatile memory 266. Especially when an abnormality diagnosis result including information on the ground fault occurrence status (the position where a ground fault occurred, the magnitude of the ground fault) is received, the battery control unit (BCU) 264 stores and holds the detection results as the basis of the abnormality diagnosis in the nonvolatile memory 266 together with identification data of the battery cell 310 relevant to the abnormality diagnosis. The information reported from the battery control unit (BCU) 264 to the integration control unit (IBCU) 226 is further reported to the system control unit (BSCU) 270 via the information bus 272.

In the battery system 201 in accordance with the present invention configured as above, a component that is equipped with a first ground fault detecting device 10-1 having the ground fault detecting function for detecting the presence/absence of occurrence of a ground fault is a first battery pack 252-1. The first battery pack 252-1 corresponds to the battery system in accordance with the first embodiment of the present invention.

<Configuration of Battery System in accordance with First Embodiment of Present Invention (First Battery Pack 252-1) and First Ground Fault Detecting Device 10-1>

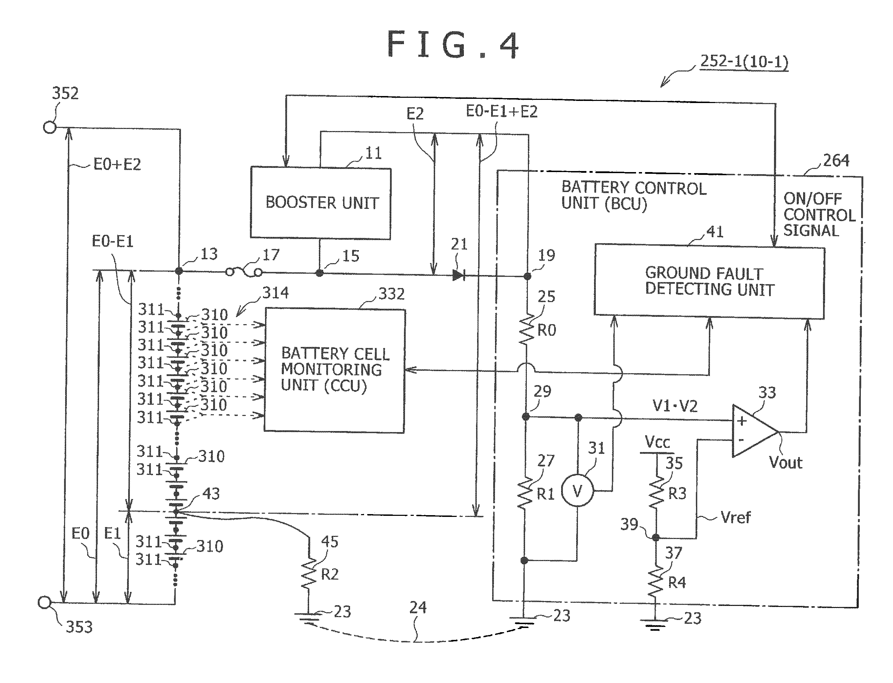

The configuration of the battery system in accordance with the first embodiment of the present invention and the first ground fault detecting device 10-1 will be described below referring to Fig. 4. Fig. 4 is a circuit configuration diagram of the first battery pack 252-1 (corresponding to the battery system in accordance with the first embodiment of the present invention) and the first ground fault detecting device 10-1.

As shown in Fig. 4, the first battery pack 252-1 is equipped with the first ground fault detecting device 10-1 having the ground fault detecting function. The first ground fault detecting device 10-1 includes the aforementioned battery module 314, a booster unit 11, a fuse 17, a diode 21, a battery control unit (BCU) 264, and a ground-fault resistance 45.

Incidentally, the fuse 17 can be left out since the fuse 17 is not an essential component in the present invention.

The battery module 314 including a plurality of battery cells 310 connected in series is inserted between the positive terminal 352 and the negative terminal 353 as shown in Fig. 3B and Fig. 4. The battery module 314 corresponds to the "DC power supply unit" in the present invention. The positive terminal 352 and the negative terminal 353 are members corresponding to "a pair of non-grounded terminals" in the present invention. Neither of the terminals 352 and 353 is grounded. The positive terminal 352 corresponds to "one of the non-grounded terminals on a high electric potential side" in the present invention, while the negative terminal 353 corresponds to "one of the non-grounded terminals on a low electric potential side" in the present invention.

A first connection point 13 connecting to the positive terminal 352 is connected via the fuse 17 to a second connection point 15 connecting to the input side of the booster unit 11 as shown in Fig. 4. Further, the booster unit 11 and the diode 21 are connected in parallel between the second connection point 15 and a third connection point 19 connecting to the output side of the booster unit 11.

The booster unit 11 is arranged on the high electric potential side (see the electric potential E0 in Fig. 4) of the battery module 314 (i.e., the first connection point 13) and has the function of outputting boosted electric potential (see the electric potential E0 + E2 in Fig. 4) acquired by boosting the high electric potential. The booster unit 11 may be implemented by properly using an isolated DC-DC converter, for example. The increment of the electric potential by the booster unit 11 (see the electric potential E2 in Fig. 4) is desired to be set within a range 5% (24 V) - 20% (96 V) with respect to the voltage capacity of the DC power supply unit (battery module 314) in cases where the voltage capacity equals 480 V, for example.

If the ratio of the increment to the high electric potential is set too low, increasing the accuracy of the ground fault detection becomes difficult even though the booster unit 11 can be formed compactly. Conversely, if the ratio of the increment to the high electric potential is set too high, compactly forming the booster unit 11 becomes difficult even though the high ratio is advantageous for increasing the accuracy of the ground fault detection.

The diode 21 is arranged in parallel to the booster unit 11, with its cathode terminal and anode terminal connected to the second connection point 15 and the third connection point 19, respectively.

The battery control unit (BCU) 264 includes a protective resistance 25, a ground fault detecting resistance 27, a voltage sensor 31, a comparator 33, a first resistance 35, a second resistance 37, and a ground fault detecting unit 41 as shown in Fig. 4.

As shown in Fig. 4, the protective resistance 25 (resistance value: R0) and the ground fault detecting resistance 27 (resistance value: R1) are connected in series between the third connection point 19 and a ground terminal 23. The resistance values R0 and R1 of the protective resistance 25 and the ground fault detecting resistance 27 are set so that R0 is sufficiently larger compared to R1. Specifically, the resistance value R0 of the protective resistance 25 may be set on the order of MΩ while setting the resistance value R1 of the ground fault detecting resistance 27 at approximately 1/20 - 1/30 of R0, for example.

Between the ground terminal 23 and a first inter-resistance connection point 29 between the protective resistance 25 and the ground fault detecting resistance 27, the voltage sensor 31 is arranged in parallel to the ground fault detecting resistance 27. The voltage sensor 31 has the function of detecting the inter-terminal voltage of the ground fault detecting resistance 27 and outputting a signal representing the detected inter-terminal voltage.

Incidentally, the first inter-resistance connection point 29 corresponds to the "inter-resistance connection point" in the present invention.

The first inter-resistance connection point 29 is connected to the non-inverted input terminal (+) of the comparator 33. In order to generate an input signal for the inverted input terminal (-) of the comparator 33, the first and second resistances 35 and 37 are connected in series between a DC power supply 34 (voltage: Vcc) and the ground terminal 23. A second inter-resistance connection point 39 between the first and second resistances 35 and 37 is connected to the inverted input terminal (-) of the comparator 33. The output terminal of the comparator 33 (output voltage: Vout) is connected to the ground fault detecting unit 41.

The ground fault detecting unit 41 has the function of detecting the ground fault occurrence status in the battery module 314 based on the result of comparison (magnitude relationship) between the electric potential of the first inter-resistance connection point 29 (between the protective resistance 25 and the ground fault detecting resistance 27) and preset threshold electric potential (electric potential Vref of the second inter-resistance connection point 39 between the first and second resistances 35 and 37). Here, the "ground fault occurrence status" is a concept including the position where a ground fault occurred and the magnitude of the ground fault as will be explained later.

Incidentally, the ground fault detecting unit 41 outputs an ON/OFF control signal (for turning ON/OFF the boosting function of the booster unit 11) to the booster unit 11.

Specifically, the ground fault detecting unit 41 judges that a ground fault has occurred in the battery module 314 if the ground fault detecting voltage V1 is judged to be above the threshold electric potential Vref when the booster unit 11 is ON. The ground fault detecting unit 41 functions according to the following mechanism:

In the normal state with no ground fault, the electric potential of the first inter-resistance connection point 29 when the booster unit 11 is ON equals partial potential $(R1 \times (E0 + E2)/(R0 + R1))$, which is calculated by partitioning the boosted electric potential (E0 + E2 shown in Fig. 4) as the sum of the high electric potential of the second connection point 15 (E0 shown in Fig. 4) and the electric potential increment (E2 shown in Fig. 4)) by using the resistance values R0 and R1 of the protective resistance 25 and the ground fault detecting resistance 27.

In contrast, in the abnormal state in which a ground fault has occurred, the electric potential of the first inter-resistance connection point 29 when the booster unit 11 is ON equals partial potential $(R1 \times (E0 - E1 + E2)/(R0 + R1 + R2))$, which is calculated by partitioning the electric potential (E0 - E1 + E2) shown in Fig. 4 (i.e., the high electric potential of the second connection point 15 (E0 shown in Fig. 4) minus a relative electric potential of a ground fault occurrence point 43 which will be explained later (E1 shown in Fig. 4) plus the electric potential increment (E2 shown in Fig. 4)) by using the resistance value R0 of the protective resistance 25 and the combined resistance value (R1 + R2) of the ground fault detecting resistance 27 (resistance value: R1) and the ground-fault resistance 45 which will be explained later (resistance value: R2).

Specifically, in the normal state with no ground fault, the ground fault detecting voltage V1 (i.e., the electric potential of the first inter-resistance connection point 29 when the booster unit 11 is ON) remains within the threshold electric potential Vref. However, in the abnormal state with a ground fault, the electric potential of the first inter-resistance connection point 29 when the booster unit 11 is ON increases from that in the normal state with no ground fault due to the energy consumption by the ground-fault resistance 45 (resistance value: R2) even if the decrease related to the relative electric potential E1 of the ground fault occurrence point 43 is taken into account. Consequently, in the abnormal state in which a ground fault has occurred, the ground fault detecting voltage V1 (the electric potential of the first inter-resistance connection point 29 when the booster unit 11 is ON) exceeds the threshold electric potential Vref.

Based on the above mechanism, the ground fault detecting unit 41 judges that a ground fault has occurred in the battery module 314 if the ground fault detecting voltage V1 is judged to be above the threshold electric potential Vref when the booster unit 11 is ON.

The threshold electric potential Vref is set in consideration of the electric potential of the first inter-resistance connection point 29 when the booster unit 11 is ON (i.e., the ground fault detecting voltage V1) in the normal state with no ground fault and that in the abnormal state with a ground fault. Specifically, the threshold electric potential Vref is set considering the intended behavior of the ground fault detecting voltage V1 in the normal state converging on a value within the threshold electric potential Vref when the booster unit 11 is ON and that of the ground fault detecting voltage V1 in the abnormal state exceeding the threshold electric potential Vref.

In the first embodiment, the lowest electromotive force is caused by a ground fault occurring at the first connection point 13 shown in Fig. 4. The ground fault detecting voltage V1 (the electric potential of the first inter-resistance connection point 29) occurring to the ground fault detecting resistance 27 (resistance value: R1) in this case can be calculated as $E2 \times R1/(R0 + R1 + R2)$. Therefore, a ground fault occurring at any position between any pair of adjoining battery cells 310 can be detected reliably if the threshold electric potential Vref is set to satisfy $Vref \leq E2 \times R1/(R0 + R1 + R2)$. It becomes clear by evaluating the setting condition of the threshold electric potential Vref that the threshold electric potential Vref can be set higher with the increase in the value of the electric potential increment E2. Thus, the accuracy of the ground fault detection can be increased by setting the electric potential increment value E2 higher.

In the normal state in which no ground fault has occurred in the battery module 314, each inter-battery connection point 311 (see Fig. 4) between adjoining battery cells 310 (see Fig. 3B) is electrically insulated from the grounding point 23. In this state, an insulating resistance having a resistance value on the order of $M\Omega$ exists between any inter-battery connection point 311 and the grounding point 23.

Suppose a ground fault has occurred at a certain inter-battery connection point 43 (see Fig. 4) in the battery module 314, a ground-fault resistance 45 having a resistance value R2 corresponding to the magnitude of the ground fault appears between the inter-battery connection point 43 (hereinafter referred to also as a "ground fault point 43") and the grounding point 23. The resistance value R2 of the ground-fault resistance 45 is lower compared to the insulating resistance on the order of $M\Omega$.

In the first battery pack 252-1 (corresponding to the battery system in accordance with the first embodiment of the present invention) and the first ground fault detecting device 10-1, the resistance value R2 of the ground-fault resistance 45 is determined and the ground fault occurrence status is judged by using the resistance value R2 as will be explained later.

<Operation of Battery System in accordance with First Embodiment of Present Invention (First Battery Pack 252-1) and First Ground Fault Detecting Device 10-1>

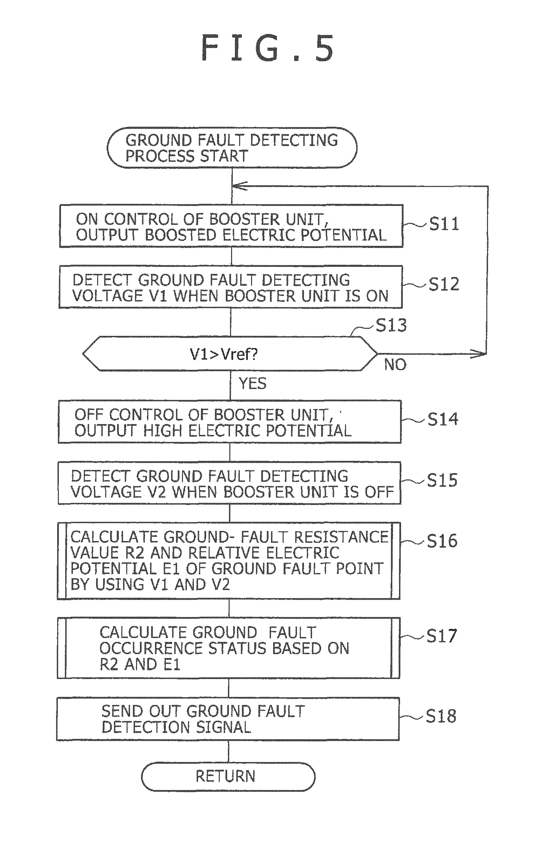

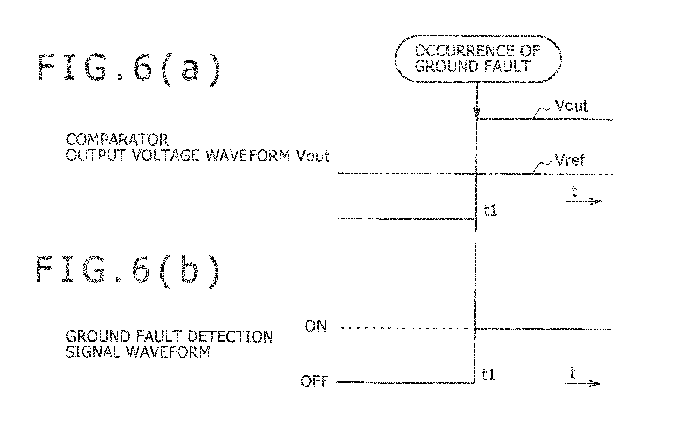

Next, the operation of the first battery pack 252-1 (corresponding to the battery system in accordance with the first embodiment of the present invention) and the first ground fault detecting device 10-1 will be described below referring to Fig. 5 and Figs. 6(a) and 6(b).

Fig. 5 is a flow chart showing the flow of a ground fault detecting process executed by the first battery pack 252-1 and the first ground fault detecting device 10-1. Fig. 6(a) is a time chart showing an output voltage waveform Vout of the comparator 33 in a case where a ground fault occurred at time t1. Fig. 6(b) is a time chart showing a ground fault detection signal waveform in the case where a ground fault occurred at time t1.

The ground fault detecting process (Fig. 5) for detecting the presence/absence of occurrence of a ground fault in the first battery pack 252-1 (first ground fault detecting device 10-1) is executed by the battery control unit (BCU) 264. The battery control unit (BCU) 264 repeatedly executes the ground fault detecting process (Fig. 5) at prescribed cycles during the operation of the first battery pack 252-1 (first ground fault detecting device 10-1). This is because appropriate countermeasures (e.g., electrically disconnecting the first battery pack 252-1 and the first ground fault detecting device 10-1 from the battery system 201 in accordance with the present invention) have to be taken immediately when the occurrence of a ground fault is detected and the magnitude of the ground fault is large.

In step S11 shown in Fig. 5, the ground fault detecting unit 41 sends the control signal for turning ON the boosting function of the booster unit 11 to the booster unit 11. In response to the control signal, the booster unit 11 outputs the boosted electric potential (E0 + E2 shown in Fig. 4) as the sum of the high electric potential of the second connection point 15 (E0 shown in Fig. 4) and the electric potential increment (E2 shown in Fig. 4). When its boosting function has been turned ON and the outputting of the boosted electric potential (E0 + E2) has started, the booster unit 11 reports the fact back to the ground fault detecting unit 41.

In step S12, upon receiving the response from the booster unit 11 regarding the boosted electric potential output, the ground fault detecting unit 41 inputs (acquires) the voltage value detected by the voltage sensor 31, by which the ground fault detecting unit 41 detects the ground fault detecting voltage V1 as the electric potential of the first inter-resistance connection point 29 when the booster unit 11 is ON.

In step S13, the ground fault detecting unit 41 compares the ground fault detecting voltage V1 detected in the step S12 with the preset threshold electric potential Vref (electric potential of the second inter-resistance connection point 39 between the first and second resistances 35 and 37).

When the ground fault detecting voltage V1 is judged to be the threshold electric potential Vref or less as the result of the comparison step S13 (step S13: No), the battery control unit (BCU) 264 returns the process flow to the step S11 and makes the ground fault detecting unit 41 execute the steps from S11.

In contrast, when the ground fault detecting voltage V1 is judged to be above the threshold electric potential Vref as the result of the comparison step S13 (step S13: Yes, see Fig. 6(a)), the battery control unit (BCU) 264 judges that a ground fault has occurred in the battery module 314 and advances the process flow to the next step S14.

In the step S14, the ground fault detecting unit 41 sends the control signal for turning OFF the boosting function of the booster unit 11 to the booster unit 11. In response to the control signal, the booster unit 11 outputs the high electric potential of the second connection point 15 (E0 shown in Fig. 4). When its boosting function has been turned OFF and the outputting of the high electric potential E0 has started, the booster unit 11 reports the fact back to the ground fault detecting unit 41.

In step S15, upon receiving the response from the booster unit 11 regarding the high electric potential output, the ground fault detecting unit 41 inputs (acquires) the voltage value detected by the voltage sensor 31, by which the ground fault detecting unit 41 detects ground fault detecting voltage V2 as the electric potential of the first inter-resistance connection point 29 when the booster unit 11 is OFF.

In step S16, the ground fault detecting unit 41 calculates the resistance value R2 of the ground-fault resistance 45 and the relative electric potential E1 of the ground fault point 43 by using the ground fault detecting voltages V1 and V2.

The details of the procedures for calculating the resistance value R2 of the ground-fault resistance 45 and the relative electric potential E1 of the ground fault point will be described later.

In step S17, the ground fault detecting unit 41 calculates the ground fault occurrence status based on the resistance value R2 of the ground-fault resistance 45 and the relative electric potential E1 of the ground fault point calculated in the step S16.

The details of the procedure for calculating the ground fault occurrence status will be described later.

In step S18, the ground fault detecting unit 41 generates a ground fault detection signal (see Fig. 6(b)) containing the ground fault occurrence status acquired by the calculation in the step S17. Then, the battery control unit (BCU) 264 sends out the generated ground fault detection signal to its upper-level integration control unit (IBCU) 226 and the system control unit (BSCU) 270. Thereafter, the battery control unit (BCU) 264 returns the process flow to the step S11 and makes the ground fault detecting unit 41 execute the steps from S11.

Each of the integration control unit (IBCU) 226 and the system control unit (BSCU) 270 receiving the ground fault detection signal judges the ground fault occurrence status and takes appropriate countermeasures (e.g., electrically disconnecting the first battery pack 252-1 and the first ground fault detecting device 10-1 from the battery system 201 in accordance with the present invention) according to the result of the judgment.

<Procedures for Calculating Resistance Value R2 of Ground-fault Resistance 45 and Relative Electric Potential E1 of Ground Fault Point>

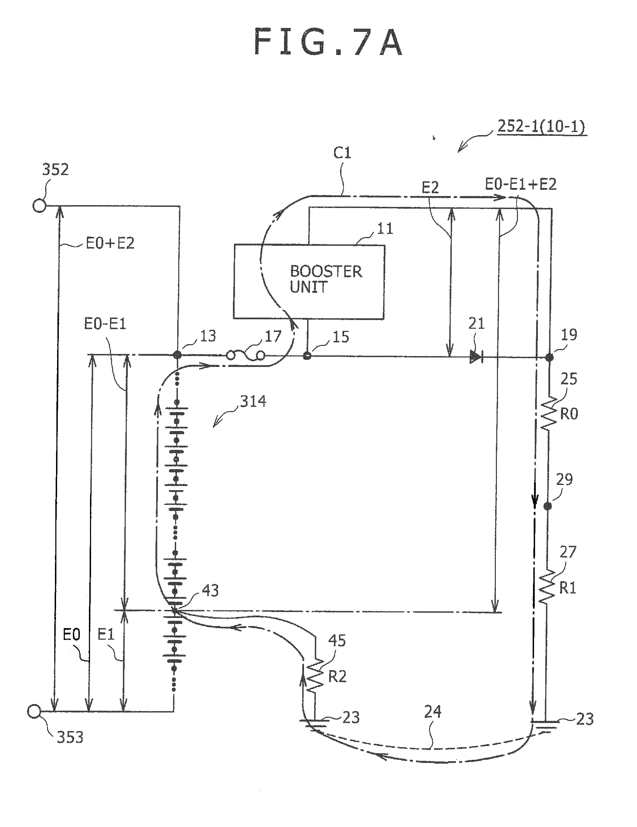

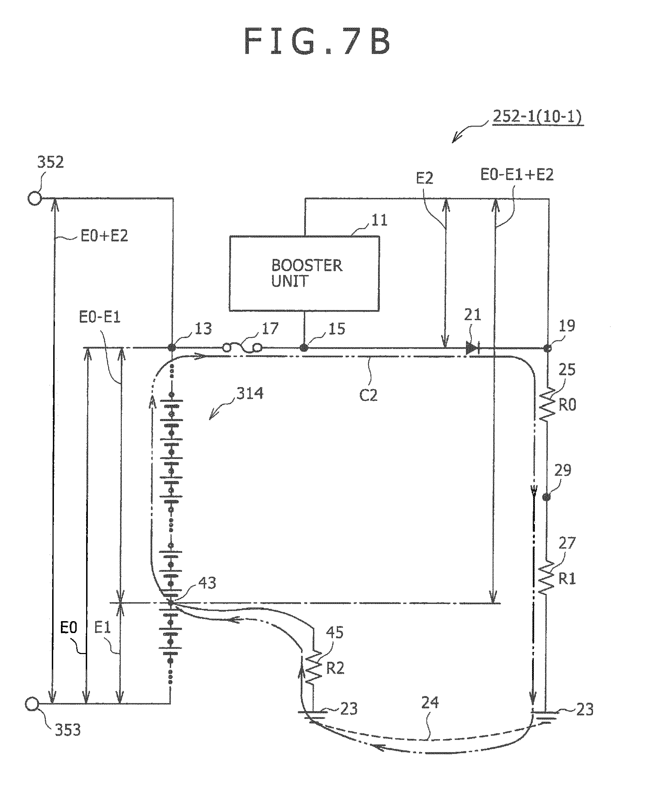

Next, the procedures for calculating the resistance value R2 of the ground-fault resistance 45 and the relative electric potential E1 of the ground fault point will be explained referring to Figs. 7A and 7B.

Fig. 7A is an explanatory diagram showing a closed-loop circuit C1 formed in the first battery pack 252-1 (first ground fault detecting device 10-1) when a ground fault has occurred at a certain inter-battery connection point (ground fault point) 43 and the output of the booster unit 11 is the boosted electric potential (with the boosting). Fig. 7B is an explanatory diagram showing a closed-loop circuit C2 formed in the first battery pack 252-1 (first ground fault detecting device 10-1) when a ground fault has occurred at a certain inter-battery connection point (ground fault point) 43 and the output of the booster unit 11 is the high electric potential (without the boosting).

First, the procedure for calculating the resistance value R2 of the ground-fault resistance 45 will be explained.

Assuming that a ground fault has occurred at a certain inter-battery connection point (ground fault point) 43 and the output of the booster unit 11 is the boosted electric potential (with the boosting), a closed-loop circuit C1 shown in Fig. 7A is formed in the first battery pack 252-1 (first ground fault detecting device 10-1). The closed-loop circuit C1 leads to the inter-battery connection point 43 (as the ground fault point) via the battery module 314, the first connection point 13, the fuse 17, the second connection point 15, the booster unit 11, the third connection point 19, the protective resistance 25, the first inter-resistance connection point 29, the ground fault detecting resistance 27, a ground terminal 23, a virtual lead 24 (connecting two ground terminals 23), another ground terminal 23, and the ground-fault resistance 45.

In this closed-loop circuit C1, the total voltage as the electromotive force is expressed as E0 - E1 + E2 and the total resistance is expressed as R0 + R1 + R2. Therefore, the electric current I1 flowing through the closed-loop circuit C1 can be represented by the following expression (1) :

$$I1 = (E0 - E1 + E2)/(R0 + R1 + R2) \quad \cdots (1)$$

By focusing on the ground fault detecting resistance R1, the ground fault detecting voltage V1 as the electric potential of the first inter-resistance connection point 29 when the booster unit 11 is ON can be detected by using the voltage sensor 31. Therefore, the electric current I1 flowing through the closed-loop circuit C1 (electric current I1 flowing through the ground fault detecting resistance R1) can be represented by the following expression (2):

$$I1 = V1/R1 \quad \cdots (2)$$

From the above expressions (1) and (2), the following expressions (3) and (4) can be derived:

$$(E0 - E1 + E2)/(R0 + R1 + R2) = V1/R1 \quad \cdots (3)$$

$$E0 - E1 + E2 = (R0 + R1 + R2) \times V1/R1 \quad \cdots (4)$$

Next, assuming that the output of the booster unit 11 is switched to the high electric potential (without the boosting) when a ground fault has occurred at a certain inter-battery connection point (ground fault point) 43, a closed-loop circuit C2 shown in Fig. 7B is formed in the first battery pack 252-1 (first ground fault detecting device 10-1). The closed-loop circuit C2 leads to the inter-battery connection point 43 (as the ground fault point) via the battery module 314, the first connection point 13, the fuse 17, the second connection point 15, the third connection point 19, the protective resistance 25, the first inter-resistance connection point 29, the ground fault detecting resistance 27, a ground terminal 23, the virtual lead 24 (connecting two ground terminals 23), another ground terminal 23, and the ground-fault resistance 45.

In this closed-loop circuit C2, the total voltage as the electromotive force is expressed as E0 - E1 and the total resistance is expressed as R0 + R1 + R2 similarly to that in the closed-loop circuit C1. Therefore, the electric current I2 flowing through the closed-loop circuit C2 can be represented by the following expression (5):

$$I2 = (E0 - E1)/(R0 + R1 + R2) \cdot\cdot\cdot (5)$$

By focusing on the ground fault detecting resistance R1, the ground fault detecting voltage V2 as the electric potential of the first inter-resistance connection point 29 when the booster unit 11 is OFF can be detected by using the voltage sensor 31. Therefore, the electric current I2 flowing through the closed-loop circuit C2 (electric current I2 flowing through the ground fault detecting resistance R1) can be represented by the following expression (6):

$$I2 = V2/R1 \cdot\cdot\cdot (6)$$

From the above expressions (5) and (6), the following expressions (7) and (8) can be derived successively:

$$(E0 - E1)/(R0 + R1 + R2) = V2/R1 \cdot\cdot\cdot (7)$$

$$E0 - E1 = (R0 + R1 + R2)\times V2/R1 \cdot\cdot\cdot (8)$$

Subsequently, by subtracting the expression (8) from the expression (4), the following expressions (9) and (10) can be derived successively:

$$E2 = (R0 + R1 + R2)\times(V1/R1 - V2/R1) \cdot\cdot\cdot (9)$$

$$R2 = (E2/(V1 - V2) - 1)\times R1 - R0 \cdot\cdot\cdot (10)$$

Since R1, R0, V1, V2 and E2 on the right side of the expression (10) are already-known values, the resistance value R2 of the ground-fault resistance 45 can be determined by substituting the values into the right side of the expression (10).

Next, the procedure for calculating the relative electric potential E1 of the ground fault point will be explained.

By modifying the expressions (4) and (8), the following expressions (11) and (12) can be derived, respectively:

$$(E0 - E1 + E2)/(V1/R1) = R0 + R1 + R2 \cdot\cdot\cdot (11)$$

$$(E0 - E1)/(V2/R1) = R0 + R1 + R2 \quad \cdots \quad (12)$$

By subtracting the expression (12) from the expression (11), the following expressions (13) - (15) can be derived successively:

$$(E0 - E1 + E2)/(V1/R1) - (E0 - E1)/(V2/R1) = 0 \quad \cdots \quad (13)$$

$$(E0 + E2) \times V2 - E0 \times V1 + (V1 - V2) \times E1 = 0 \quad \cdots \quad (14)$$

$$E1 = E0 - E2 \times V2/(V1 - V2) \quad \cdots \quad (15)$$

Since V1, V2, E0 and E2 on the right side of the expression (15) are already-known values, the relative electric potential E1 of the ground fault point can be determined by substituting the values into the right side of the expression (15).

The resistance value R2 of the ground-fault resistance 45 is on the order of MΩ in the normal state with no ground fault. In the abnormal state with a ground fault, however, the value decreases depending on the magnitude of the ground fault. Therefore, it is possible to recognize the magnitude (small, middle or large) of the ground fault at the ground fault point (inter-battery connection point) 43 through evaluation of the resistance value R2 of the ground-fault resistance 45.

Meanwhile, the relative electric potential E1 of the ground fault point equals zero in the normal state with no ground fault. In the abnormal state with a ground fault, however, the value changes depending on the position of the ground fault point in the battery module 314. Therefore, it is possible to uniquely determine the position of the ground fault point in the battery module 314 by previously setting each electric potential range to which each of the inter-battery connection points belongs and thereafter checking to which of the electric potential ranges (i.e., to which of the inter-battery connection points) the relative electric potential E1 of the ground fault point corresponds.

Specifically, assuming that the charging voltage of each battery cell 310 equals 3V, for example, each electric potential range to which each of the inter-battery connection points (L1 - L3) belongs is previously set such as an electric potential range 2.7 V - 3.3 V for the inter-battery connection point L1 at the lowest electric potential, an electric potential range 5.7 V - 6.3 V for the inter-battery connection point L2 adjoining (on the high potential side of) the inter-battery connection point L1 at the lowest electric potential, and an electric potential range 8.7 V - 9.3 V for the inter-battery connection point L3 adjoining (on the high potential side of) the inter-battery connection point L2. Data regarding each electric potential range to which each of the inter-battery connection points (L1 - L3) belongs is stored and managed in the battery cell monitoring unit (CCU) 332.

In this case, if the relative electric potential E1 of the ground fault point equals 6.1 V, for example, the relative electric potential E1 (6.1 V) belongs to the electric potential range 5.7 V - 6.3 V for the inter-battery connection point L2. Thus, the ground fault detecting unit 41 can uniquely determine that the position of the ground fault point in the battery module 314 is the inter-battery connection point L2 adjoining (on the high potential side of) the inter-battery connection point L1 at the lowest electric potential based on the relative electric potential E1 of the ground fault point and the data regarding each electric potential range (to which each of the inter-battery connection points L1 - L3 belongs) stored and managed in the battery cell monitoring unit (CCU) 332.

<Effect of Battery System in accordance with First Embodiment of Present Invention (First Battery Pack 252-1) and First Ground Fault Detecting Device 10-1>

As shown in Fig. 4, the first battery pack 252-1 (corresponding to the battery system in accordance with the first embodiment of the present invention) and the first ground fault detecting device 10-1 employ the configuration comprising a DC power supply unit (battery module 314) which includes a plurality of battery cells 310 connected in series between a pair of non-grounded terminals (positive terminal 352, negative terminal 353), ground-fault resistances 45 each of which appears between a grounding point 23 and an inter-battery connection point 311 between adjoining ones of the battery cells 310, a booster unit 11 which is provided to one of the non-grounded terminals (positive terminal 352, negative terminal 353) on a high electric potential side (positive terminal 352) and outputs boosted electric potential acquired by boosting the high electric potential, a protective resistance 25 and a ground fault detecting resistance 27 which are provided in series between the output side of the booster unit 11 (third connection point 19) and the grounding point 23, and a ground fault detecting unit 41 which detects the presence/absence of a ground fault in the DC power supply unit (battery module 314) based on the result of comparison between preset threshold electric potential Vref and electric potential of an inter-resistance connection point 29 between the protective resistance 25 and the ground fault detecting resistance 27.

According to the first battery pack 252-1 (corresponding to the battery system in accordance with the first embodiment of the present invention) and the first ground fault detecting device 10-1, the boosted electric potential (E0 + E2) acquired by boosting the high electric potential (E0) of the DC power supply unit (battery module 314) is employed as the ground fault detection reference electric potential. Therefore, the presence/absence of a ground fault can be detected accurately in real time with a simple configuration by use of a single ground fault detection reference electric potential without causing the so-called "dead zone" (ground fault detection disabling electric potential).

Further, the ground fault detecting unit 41 is configured to detect that a ground fault has occurred in the DC power supply unit (battery module 314) when the electric potential of the inter-resistance connection point 29 between the protective resistance 25 and the ground fault detecting resistance 27 exceeds (crosses upward) the threshold electric potential Vref.

With such a configuration, the presence/absence of a ground fault can be detected accurately in real time with a simple configuration through the judgment on whether the electric potential of the inter-resistance connection point 29 between the protective resistance 25 and the ground fault detecting resistance 27 has exceeded (crossed upward) the threshold electric potential Vref or not.

The booster unit 11 may have a function of outputting the high electric potential (E0) or the boosted electric potential (E0 + E2) by switching between the two electric potentials, and the ground fault detecting unit 41 may be configured to detect the ground fault occurrence status in the DC power supply unit (battery module 314) by using electric potential of the inter-resistance connection point 29 when the output of the booster unit 11 is the boosted electric potential and electric potential of the inter-resistance connection point 29 when the output of the booster unit 11 is the high electric potential.

With such a configuration, the ground fault occurrence status in the DC power supply unit (battery module 314) can be detected while also achieving the aforementioned effects. Thus, it becomes possible to grasp detailed information on the ground fault occurrence status and immediately take appropriate countermeasures against the ground fault (e.g., electrically disconnecting the first battery pack 252-1 and the first ground fault detecting device 10-1 from the battery system 201 in accordance with the present invention) based on the grasped detailed information.

<Configuration of Battery System in accordance with Second Embodiment of Present Invention (Second Battery Pack 252-2) and Second Ground Fault Detecting Device 10-2>

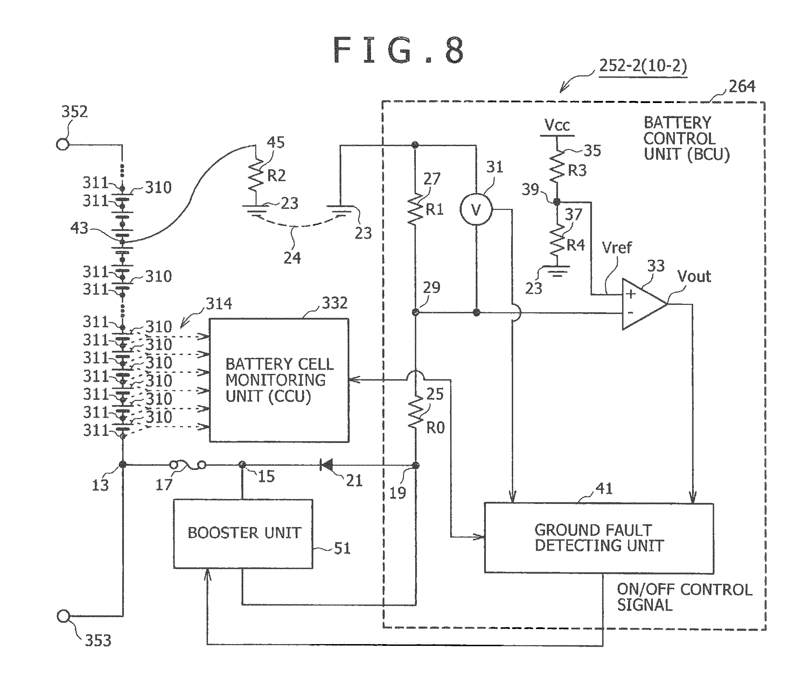

The configuration of a battery system in accordance with a second embodiment of the present invention and a second ground fault detecting device 10-2 will be described below referring to Fig. 8. Fig. 8 is a circuit configuration diagram of a second battery pack 252-2 (corresponding to the battery system in accordance with the second embodiment of the present invention) and the second ground fault detecting device 10-2.

The configuration of the second battery pack 252-2 and the second ground fault detecting device 10-2 is basically equivalent to that of the first battery pack 252-1 and the first ground fault detecting device 10-1 except that a step-down unit 51 is employed instead of the booster unit 11. Therefore, the following explanation of the battery system in accordance with the second embodiment of the present invention (second battery pack 252-2) and the second ground fault detecting device 10-2 will be given by just explaining the difference between the two embodiments.

While the boosted electric potential (E0 + E2) acquired by boosting the high electric potential (E0) of the DC power supply unit (battery module 314) with the booster unit 11 was employed as the ground fault detection reference electric potential in the first battery pack 252-1 and the first ground fault detecting device 10-1, reduced electric potential acquired by stepping down low electric potential (e.g., 0 V) of the DC power supply unit (battery module 314) with the step-down unit 51 is employed as the ground fault detection reference electric potential in the second battery pack 252-2 and the second ground fault detecting device 10-2. The step-down unit 51 may be implemented by properly using an isolated DC-DC converter, for example.

Similarly to the case of the booster unit 11, the decrement of the electric potential by the step-down unit 51 is desired to be set within a range 5% (24 V) - 20% (96 V) with respect to the voltage capacity of the DC power supply unit (battery module 314) in cases where the voltage capacity equals 480 V, for example. The reason for the setting of the step-down unit 51 is equivalent to that of the booster unit 11.

With the employment of the step-down unit 51, the voltage polarity relationship in the second battery pack 252-2 and the second ground fault detecting device 10-2 is inverted compared to that in the first battery pack 252-1 and the first ground fault detecting device 10-1. Specifically, in the second battery pack 252-2 and the second ground fault detecting device 10-2, the diode 21 (connected in parallel to the step-down unit 51) is arranged with its cathode terminal connected to the third connection point 19 and with its anode terminal connected to the second connection point 15 (in the reverse direction compared to the diode 21 in the first battery pack 252-1 and the first ground fault detecting device 10-1).

<Effect of Battery System in accordance with Second Embodiment of Present Invention (Second Battery Pack 252-2) and Second Ground Fault Detecting Device 10-2>

As shown in Fig. 8, the second battery pack 252-2 (corresponding to the battery system in accordance with the second embodiment of the present invention) and the second ground fault detecting device 10-2 employ the configuration comprising a DC power supply unit (battery module 314) which includes a plurality of battery cells 310 connected in series between a pair of non-grounded terminals (positive terminal 352, negative terminal 353), ground-fault resistances 45 each of which appears between a grounding point 23 and an inter-battery connection point 311 between adjoining ones of the battery cells 310, a step-down unit 51 which is provided to one of the non-grounded terminals (positive terminal 352, negative terminal 353) on a low electric potential side (negative terminal 353) and outputs reduced electric potential acquired by stepping down the low electric potential, a protective resistance 25 and a ground fault detecting resistance 27 which are provided in series between the output side of the step-down unit 51 (third connection point 19) and the grounding point 23, and a ground fault detecting unit 41 which detects the presence/absence of a ground fault in the DC power supply unit (battery module 314) based on the result of comparison between preset threshold electric potential Vref and electric potential of an inter-resistance connection point 29 between the protective resistance 25 and the ground fault detecting resistance 27.

It is desirable also in the second embodiment that the threshold electric potential Vref be set appropriately according to the basic idea described in the first embodiment, by assuming a case where a ground fault has occurred at the first connection point 13 shown in Fig. 8.

According to the second battery pack 252-2 (corresponding to the battery system in accordance with the second embodiment of the present invention) and the second ground fault detecting device 10-2, the reduced electric potential acquired by stepping down the low electric potential of the DC power supply unit (battery module 314) is employed as the ground fault detection reference electric potential. Therefore, the presence/absence of a ground fault can be detected accurately in real time with a simple configuration by use of a single ground fault detection reference electric potential without causing the so-called "dead zone" (ground fault detection disabling electric potential).

Further, the ground fault detecting unit 41 is configured to detect that a ground fault has occurred in the DC power supply unit (battery module 314) when the electric potential of the inter-resistance connection point 29 between the protective resistance 25 and the ground fault detecting resistance 27 falls below (crosses downward) the threshold electric potential Vref.

With such a configuration, the presence/absence of a ground fault can be detected accurately in real time with a simple configuration through the judgment on whether the electric potential of the inter-resistance connection point 29 between the protective resistance 25 and the ground fault detecting resistance 27 has fallen below (crossed downward) the threshold electric potential Vref or not.

The step-down unit 51 may have a function of outputting the low electric potential or the reduced electric potential by switching between the two electric potentials, and the ground fault detecting unit 41 may be configured to detect the ground fault occurrence status in the DC power supply unit (battery module 314) by using electric potential of the inter-resistance connection point 29 when the output of the step-down unit 51 is the reduced electric potential and electric potential of the inter-resistance connection point 29 when the output of the step-down unit 51 is the low electric potential.

With such a configuration, the ground fault occurrence status in the DC power supply unit (battery module 314) can be detected while also achieving the aforementioned effects. Thus, it becomes possible to grasp detailed information on the ground fault occurrence status and immediately take appropriate countermeasures against the ground fault (e.g., electrically disconnecting the first battery pack 252-1 and the first ground fault detecting device 10-1 from the battery system 201 in accordance with the present invention) based on the grasped detailed information.

<Other Embodiments>

The embodiments described above are illustrations of particular examples embodying the present invention. Therefore, the technical scope of the present invention should not be interpreted restrictively due to the above embodiments. That is because the present invention is implementable in a variety of forms without departing from its subject matter or principal features.

For example, while a battery pack in which the occurrence of a ground fault has been detected is electrically disconnected from the battery system 201 in accordance with the present invention in case of detection of the occurrence of a ground fault in one of the first and second battery packs 252-1 and 252-2 in the above explanation of the battery systems in accordance with the first and second embodiments of the present invention, the present invention is not restricted to this example.

It is also possible to employ a configuration that electrically disconnects one or more battery packs (in which the occurrence of a ground fault has been detected) from the battery system(s) 201 in accordance with the present invention and reports or warns of the fact in case of detection of the occurrence of a ground fault in one or both of a battery system in accordance with the first embodiment and a battery system in accordance with the second embodiment.

While a ground fault detecting device in which the occurrence of a ground fault has been detected is electrically disconnected from the battery system 201 in accordance with the present invention in case of detection of the occurrence of a ground fault in one of the first and second ground fault detecting devices 10-1 and 10-2 in the above explanation of the first and second ground fault detecting devices 10-1 and 10-2 in accordance with the present invention, the present invention is not restricted to this example.

It is also possible to employ a configuration that electrically disconnects one or more ground fault detecting devices (in which the occurrence of a ground fault has been detected) from the battery system 201 in accordance with the present invention and reports or warns of the fact in case of detection of the occurrence of a ground fault in one or both of the first and second ground fault detecting devices 10-1 and 10-2.

Description of Reference Characters

| | |
|---|---|
| 10-1 | first ground fault detecting device (ground fault detecting device) |
| 10-2 | second ground fault detecting device (ground fault detecting device) |
| 11 | booster unit |
| 13 | first connection point |
| 15 | second connection point |
| 17 | fuse |
| 19 | third connection point |
| 21 | diode |
| 23 | grounding point |
| 25 | protective resistance |
| 27 | ground fault detecting resistance |
| 29 | first inter-resistance connection point (inter-resistance connection point) |
| 31 | voltage sensor |
| 33 | comparator |
| 35 | first resistance |
| 37 | second resistance |
| 39 | second inter-resistance connection point |
| 41 | ground fault detecting unit |
| 43 | ground fault occurrence point (inter-battery connection point) |
| 45 | ground-fault resistance |
| 51 | step-down unit |
| 201 | battery system in accordance with the present invention |
| 252-1 | first battery pack (battery system in accordance with the first embodiment of the present invention) |
| 252-2 | second battery pack (battery system in accordance with the second embodiment of the present invention) |
| 226 | integration control unit (IBCU) |
| 264 | battery control unit (BCU) |
| 270 | system control unit (BSCU) |
| 310 | battery cell |
| 311 | inter-battery connection point |
| 314 | battery module |
| 332 | battery cell monitoring unit (CCU) |
| 352 | positive terminal (one of the non-grounded terminals on the high electric potential side) |
| 353 | negative terminal (one of the non-grounded terminals on the low electric potential side) |

**Claims**

1. A battery system comprising:

a DC power supply unit which includes a plurality of batteries connected in series between a pair of non-grounded terminals;

ground-fault resistances each of which appears between a grounding point and an inter-battery connection point between adjoining ones of the batteries;

a booster unit which is provided to one of the non-grounded terminals on a high electric potential side and outputs boosted electric potential acquired by boosting the high electric potential;

a protective resistance and a ground fault detecting resistance which are provided in series between the output side of the booster unit and the grounding point; and

a ground fault detecting unit which detects the presence/absence of a ground fault in the DC power supply unit based on the result of comparison between preset threshold electric potential and electric potential of an inter-resistance connection point between the protective resistance and the ground fault detecting resistance.

2. A battery system comprising:

a DC power supply unit which includes a plurality of batteries connected in series between a pair of non-grounded terminals;

ground-fault resistances each of which appears between a grounding point and an inter-battery connection point between adjoining ones of the batteries;

a step-down unit which is provided to one of the non-grounded terminals on a low electric potential side and outputs reduced electric potential acquired by stepping down the low electric potential;

a protective resistance and a ground fault detecting resistance which are provided in series between the output side of the step-down unit and the grounding point; and

a ground fault detecting unit which detects the presence/absence of a ground fault in the DC power supply unit based on the result of comparison between preset threshold electric potential and electric potential of an inter-resistance connection point between the protective resistance and the ground fault detecting resistance.

3. The battery system according to claim 1 or 2, wherein the ground fault detecting unit detects that a ground fault has occurred in the DC power supply unit when the electric potential of the inter-resistance connection point has crossed the threshold electric potential.

4. The battery system according to claim 1, wherein:

the booster unit has a function of outputting the high electric potential or the boosted electric potential by switching between the two electric potentials, and

the ground fault detecting unit detects ground fault occurrence status in the DC power supply unit by using electric potential of the inter-resistance connection point when the output of the booster unit is the boosted electric potential and electric potential of the inter-resistance connection point when the output of the booster unit is the high electric potential.

5. The battery system according to claim 2, wherein:

the step-down unit has a function of outputting the high electric potential or the reduced electric potential by switching between the two electric potentials, and

the ground fault detecting unit detects ground fault occurrence status in the DC power supply unit by using electric potential of the inter-resistance connection point when the output of the step-down unit is the low electric potential and electric potential of the inter-resistance connection point when the output of the step-down unit is the reduced electric potential.

6. A ground fault detecting device comprising:

a DC power supply unit which includes a plurality of batteries connected in series between a pair of non-grounded terminals;

ground-fault resistances each of which appears between a grounding point and an inter-battery connection point between adjoining ones of the batteries;

a booster unit which is provided to one of the non-grounded terminals on a high electric potential side and outputs boosted electric potential acquired by boosting the high electric potential;

a protective resistance and a ground fault detecting resistance which are provided in series between the output side of the booster unit and the grounding point; and

a ground fault detecting unit which detects the presence/absence of a ground fault in the DC power supply unit based on the result of comparison between preset threshold electric potential and electric potential of an inter-resistance connection point between the protective resistance and the ground fault detecting resistance.

7. A ground fault detecting device comprising:

a DC power supply unit which includes a plurality of batteries connected in series between a pair of non-grounded terminals;

ground-fault resistances each of which appears between a grounding point and an inter-battery connection point between adjoining ones of the batteries;

a step-down unit which is provided to one of the non-grounded terminals on a low electric potential side and outputs reduced electric potential acquired by stepping down the low electric potential;

a protective resistance and a ground fault detecting resistance which are provided in series between the output side of the step-down unit and the grounding point; and

a ground fault detecting unit which detects the presence/absence of a ground fault in the DC power supply unit based on the result of comparison between preset threshold electric potential and electric potential of an inter-resistance connection point between the protective resistance and the ground fault detecting resistance.

8. The ground fault detecting device according to claim 6 or 7, wherein the ground fault detecting unit detects that a ground fault has occurred in the DC power supply unit when the electric potential of the inter-resistance connection point has crossed the threshold electric potential.

9. The ground fault detecting device according to claim 6, wherein:

the booster unit has a function of outputting the high electric potential or the boosted electric potential by switching between the two electric potentials, and

the ground fault detecting unit detects ground fault occurrence status in the DC power supply unit by using electric potential of the inter-resistance connection point when the output of the booster unit is the boosted electric potential and electric potential of the inter-resistance connection point when the output of the booster unit is the high electric potential.

10. The ground fault detecting device according to claim 7, wherein:

the step-down unit has a function of outputting the high electric potential or the reduced electric potential by switching between the two electric potentials, and

the ground fault detecting unit detects ground fault occurrence status in the DC power supply unit by using electric potential of the inter-resistance connection point when the output of the step-down unit is the low electric potential and electric potential of the inter-resistance connection point when the output of the step-down unit is the reduced electric potential.

**Amended claims under Art. 19.1 PCT**

1. (Amended) A battery system comprising:

a DC power supply unit which includes a plurality of batteries connected in series between a pair of non-grounded terminals;

ground-fault resistances each of which appears between a grounding point and an inter-battery connection point between adjoining ones of the batteries;

a booster unit which is provided to one of the non-grounded terminals on a high electric potential side and outputs boosted electric potential acquired by boosting the high electric potential;

a protective resistance and a ground fault detecting resistance which are provided in series between the output side of the booster unit and the grounding point; and

a ground fault detecting unit which detects the presence/absence of a ground fault in the DC power supply unit based on the result of comparison between preset threshold electric potential and electric potential of an inter-resistance connection point between the protective resistance and the ground fault detecting resistance, wherein:

the booster unit has a function of outputting the high electric potential or the boosted electric potential by switching between the two electric potentials, and

the ground fault detecting unit detects ground fault occurrence status in the DC power supply unit by using electric potential of the inter-resistance connection point when the output of the booster unit is the boosted electric potential and electric potential of the inter-resistance connection point when the output of the booster unit is the high electric potential.

2. (Amended) A battery system comprising:

a DC power supply unit which includes a plurality of batteries connected in series between a pair of non-grounded terminals;

ground-fault resistances each of which appears between a grounding point and an inter-battery connection point between adjoining ones of the batteries;

a step-down unit which is provided to one of the non-grounded terminals on a low electric potential side and outputs reduced electric potential acquired by stepping down the low electric potential;

a protective resistance and a ground fault detecting resistance which are provided in series between the output side of the step-down unit and the grounding point; and

a ground fault detecting unit which detects the presence/absence of a ground fault in the DC power supply unit based on the result of comparison between preset threshold electric potential and electric potential of an inter-resistance connection point between the protective resistance and the ground fault detecting resistance, wherein:

the step-down unit has a function of outputting the low electric potential or the reduced electric potential by switching between the two electric potentials, and

the ground fault detecting unit detects ground fault occurrence status in the DC power supply unit by using electric potential of the inter-resistance connection point when the output of the step-down unit is the low electric potential and electric potential of the inter-resistance connection point when the output of the step-down unit is the reduced electric potential.

3. The battery system according to claim 1 or 2, wherein the ground fault detecting unit detects that a ground fault has occurred in the DC power supply unit when the electric potential of the inter-resistance connection point has crossed the threshold electric potential.

4. (Deleted)

5. (Deleted)

6. (Amended) A ground fault detecting device comprising:

a DC power supply unit which includes a plurality of batteries connected in series between a pair of non-grounded terminals;

ground-fault resistances each of which appears between a grounding point and an inter-battery connection point between adjoining ones of the batteries;

a booster unit which is provided to one of the non-grounded terminals on a high electric potential side and outputs boosted electric potential acquired by boosting the high electric potential;

a protective resistance and a ground fault detecting resistance which are provided in series between the output side of the booster unit and the grounding point; and

a ground fault detecting unit which detects the presence/absence of a ground fault in the DC power supply unit based on the result of comparison between preset threshold electric potential and electric potential of an inter-resistance connection point between the protective resistance and the ground fault detecting resistance, wherein:

the booster unit has a function of outputting the high electric potential or the boosted electric potential by switching between the two electric potentials, and

the ground fault detecting unit detects ground fault occurrence status in the DC power supply unit by using electric potential of the inter-resistance connection point when the output of the booster unit is the boosted electric potential and electric potential of the inter-resistance connection point when the output of the booster unit is the high electric potential.

**7.** (Amended) A ground fault detecting device comprising:

a DC power supply unit which includes a plurality of batteries connected in series between a pair of non-grounded terminals;

ground-fault resistances each of which appears between a grounding point and an inter-battery connection point between adjoining ones of the batteries;

a step-down unit which is provided to one of the non-grounded terminals on a low electric potential side and outputs reduced electric potential acquired by stepping down the low electric potential;

a protective resistance and a ground fault detecting resistance which are provided in series between the output side of the step-down unit and the grounding point; and

a ground fault detecting unit which detects the presence/absence of a ground fault in the DC power supply unit based on the result of comparison between preset threshold electric potential and electric potential of an inter-resistance connection point between the protective resistance and the ground fault detecting resistance.

the step-down unit has a function of outputting the low electric potential or the reduced electric potential by switching between the two electric potentials, and

the ground fault detecting unit detects ground fault occurrence status in the DC power supply unit by using electric potential of the inter-resistance connection point when the output of the step-down unit is the low electric potential and electric potential of the inter-resistance connection point when the output of the step-down unit is the reduced electric potential.

**8.** The ground fault detecting device according to claim 6 or 7, wherein the ground fault detecting unit detects that a ground fault has occurred in the DC power supply unit when the electric potential of the inter-resistance connection point has crossed the threshold electric potential.

**9.** (Deleted)

**10.** (Deleted)

**Statement under Art. 19.1 PCT**

Claim 1 has been amended to reduce the scope of the original Claim 1 filed at the time of the application by the contents of the original Claim 4. According to the amendment, Claim 4 has been deleted.

Claim 2 has been amended to reduce the scope of the original Claim 2 filed at the time of the application by the contents of the original Claim 5. According to the amendment, Claim 5 has been deleted.

Claim 6 has been amended to reduce the scope of the original Claim 6 filed at the time of the application by the contents of the original Claim 9. According to the amendment, Claim 9 has been deleted.

Claim 7 has been amended to reduce the scope of the original Claim 7 filed at the time of the application by the contents of the original Claim 10. According to the amendment, Claim 10 has been deleted.

According to the present invention, the presence/absence of a ground fault can be detected accurately in real time with a simple configuration. Since the ground fault occurrence status in the DC power supply unit can be detected according to the present invention, it becomes possible to grasp detailed information on the ground fault occurrence status and immediately take appropriate countermeasures against the ground fault (e.g., electrically disconnecting the first battery pack 252-1 and the first ground fault detecting device 10-1 from the battery system 201 in accordance with the present invention) based on the grasped detailed information.

# FIG.1

101

103

POWER GENERATION PLANT

(WIND POWER GENERATION, HYDROELECTRIC POWER GENERATION, PHOTOVOLTAIC POWER GENERATION, ETC.)

A

105

102

INVERTER ~104

BATTERY SYSTEM ~201

EP 2 808 687 A1

# FIG.2

201

270

| SYSTEM CONTROL UNIT (BSCU) |
|---|

212          212  212

BATTERY BLOCK

226

| INTEGRATION CONTROL UNIT (IBCU) |
|---|

252          252  252

BATTERY PACK

264

| BATTERY CONTROL UNIT (BCU) |
|---|

314          314  314

BATTERY MODULE

332

| BATTERY CELL MONITORING UNIT (CCU) |
|---|

310          310          310

| BATTERY CELL | | BATTERY CELL | | BATTERY CELL | ... |

...

...

...

# FIG.3A

# FIG.3B

# FIG.4

252-1(10-1)

352

E0+E2

E0-E1

E2    E0-E1+E2

BOOSTER UNIT  11

BATTERY CONTROL
UNIT (BCU)

ON/OFF
CONTROL
SIGNAL

264

GROUND FAULT
DETECTING UNIT  41

13    17    15    21    19

311 310 314 332
311 310
311 310
311 310    BATTERY CELL
311 310    MONITORING
311 310    UNIT (CCU)
311

25  R0

311 310
311

43

29

V1·V2

33

311 310    45
311        R2

E0  E1

23    24

31  V

27  R1

35  R3
Vcc

39

37  R4

Vref

Vout

23    23

353

EP 2 808 687 A1

# FIG.5

```
┌─────────────────────────────┐
│   GROUND FAULT DETECTING     │
│   PROCESS START              │
└─────────────────────────────┘
              │
              ▼
┌─────────────────────────────────┐
│ ON CONTROL OF BOOSTER UNIT,     │ ～S11
│ OUTPUT BOOSTED ELECTRIC POTENTIAL│
└─────────────────────────────────┘
              │
              ▼
┌─────────────────────────────────┐
│ DETECT GROUND FAULT DETECTING   │ ～S12
│ VOLTAGE V1 WHEN BOOSTER UNIT IS ON│
└─────────────────────────────────┘
              │                    ～S13
              ▼
        ＜ V1>Vref? ＞──── NO ────┐
              │                    │
             YES                   │
              ▼                    │
┌─────────────────────────────────┐│
│ OFF CONTROL OF BOOSTER UNIT,    ││ ～S14
│ OUTPUT HIGH ELECTRIC POTENTIAL  ││
└─────────────────────────────────┘│
              │                    │
              ▼                    │
┌─────────────────────────────────┐│
│ DETECT GROUND FAULT DETECTING   ││ ～S15
│ VOLTAGE V2 WHEN BOOSTER UNIT IS OFF││
└─────────────────────────────────┘│
              │                    │
              ▼                    │
┌─────────────────────────────────┐│
│ CALCULATE GROUND- FAULT RESISTANCE││ ～S16
│ VALUE R2 AND RELATIVE ELECTRIC  ││
│ POTENTIAL E1 OF GROUND FAULT POINT││
│ BY USING V1 AND V2              ││
└─────────────────────────────────┘│
              │                    │
              ▼                    │
┌─────────────────────────────────┐│
│ CALCULATE GROUND  FAULT         ││ ～S17
│ OCCURRENCE STATUS BASED ON      ││
│ R2 AND E1                       ││
└─────────────────────────────────┘│
              │                    │
              ▼                    │
┌─────────────────────────────────┐│
│ SEND OUT GROUND FAULT           ││ ～S18
│ DETECTION SIGNAL                ││
└─────────────────────────────────┘│
              │                    │
              ▼                    │
        ┌───────────┐              │
        │  RETURN   │──────────────┘
        └───────────┘
```

27

FIG.6(a)

COMPARATOR
OUTPUT VOLTAGE WAVEFORM Vout

OCCURRENCE OF
GROUND FAULT

~Vout

~Vref

t

t1

FIG.6(b)

GROUND FAULT DETECTION
SIGNAL WAVEFORM

ON

OFF

t1

t

# FIG.7A

# FIG.7B

# FIG.8

| **INTERNATIONAL SEARCH REPORT** | International application No. |
| --- | --- |
| | PCT/JP2011/080173 |

**A. CLASSIFICATION OF SUBJECT MATTER**
*G01R31/02*(2006.01)i

According to International Patent Classification (IPC) or to both national classification and IPC

**B. FIELDS SEARCHED**

Minimum documentation searched (classification system followed by classification symbols)
B60L3/00, G01R27/00-27/32, G01R31/02-06, H02H3/14, H02H3/16

Documentation searched other than minimum documentation to the extent that such documents are included in the fields searched

| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X<br>Y<br>A | JP 2003-169401 A (Sanyo Electric Co., Ltd.),<br>13 June 2003 (13.06.2003),<br>paragraphs [0002], [0022], [0023]; fig. 4<br>(Family: none) | 1,3,6,8<br>2,7<br>4,5,9,10 |
| Y<br>A | CD-ROM of the specification and drawings<br>annexed to the request of Japanese Utility<br>Model Application No. 4289/1992(Laid-open<br>No. 64783/1993)<br>(Kawaju Bosai Kogyo Kabushiki Kaisha),<br>27 August 1993 (27.08.1993),<br>paragraphs [0014], [0015]; fig. 3<br>(Family: none) | 2,7<br>4,5,9,10 |

| ☒ Further documents are listed in the continuation of Box C. | ☐ See patent family annex. |
| --- | --- |

| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 03 April, 2012 (03.04.12) | 17 April, 2012 (17.04.12) |

| Name and mailing address of the ISA/ | Authorized officer |
| --- | --- |
| Japanese Patent Office | |
| Facsimile No. | Telephone No. |

Form PCT/ISA/210 (second sheet) (July 2009)

**INTERNATIONAL SEARCH REPORT**

International application No.

PCT/JP2011/080173

C (Continuation).    DOCUMENTS CONSIDERED TO BE RELEVANT

| Category* | Citation of document, with indication, where appropriate, of the relevant passages | Relevant to claim No. |
|---|---|---|
| A | JP 6-153303 A  (Matsushita Electric Industrial Co., Ltd.), 31 May 1994 (31.05.1994), paragraphs [0011], [0012]; fig. 1 (Family: none) | 4,5,9,10 |
| A | JP 2000-197201 A  (Denso Corp.), 14 July 2000 (14.07.2000), paragraphs [0018] to [0020]; fig. 1 (Family: none) | 4,5,9,10 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• JP 2005189005 A